# EUROPÄISCHE PATENTANMELDUNG

(11) **EP 1 592 291 A2**
(43) Veröffentlichungstag der Anmeldung: **02.11.2005**
(21) Anmeldenummer: 05103526.9
(22) Anmeldetag: 28.04.2005
(51) Int. Cl.: H05K 5/00

(54) **Steckverbinder und Elektronikeinheit mit einem solchen Steckverbinder sowie Verfahren zum Herstellen einer Elektronikeinheit**

(30) Priorität: 29.04.2004 DE 102004021148
(71) Anmelder: SIEMENS AKTIENGESELLSCHAFT, 80333 München (DE)
(72) Erfinder: Gruber, Robert, 93049, Regensburg (DE)

(57) **Zusammenfassung**

Die Elektronikeinheit (10) zeichnet sich durch einen Steckverbinder (S) aus, der zumindest zwei Kontaktstifte (K1, K2) aufweist, die jeweils eine Einpresszone (EZ1, EZ2) aufweisen, deren Einpressrichtung um 180° gedreht ist. Auf diese Weise kann der Steckverbinder (S) mit einer ersten Leiterplatte (L1) und anschließend mit einer zweiten Leiterplatte (L2) durch Einpressverbindungen verbunden werden. Die Elektronikeinheit (10) zeichnet sich weiter durch elektromagnetische abgeschirmte Kammern (1, 2, 3) aus.

## Beschreibung

Die vorliegende Erfindung betrifft einen Steckverbinder und eine Elektronikeinheit mit einem solchen Steckverbinder, insbesondere ein Steuergerät für ein Kraftfahrzeug, sowie ein Verfahren zum Herstellen einer Elektronikeinheit.

Elektronische Geräte weisen häufig einen Steckverbinder auf, der dazu dient, das Gerät mit elektrischer Energie zu versorgen und elektrische Verbindungen zu anderen Ein- oder Ausgabegeräten herzustellen.

Diese Steckverbinder weisen Kontaktstifte auf die mit Kontaktflächen einer Leiterplatte elektrisch verbunden sind. Diese Verbindungen werden häufig durch Löten oder Einpressen hergestellt. Die aus Steckverbinder und Leiterplatte bestehende Baugruppe muss, um Anforderungen aufgrund von Umgebungsbedingungen zu erfüllen, zumeist in ein Gehäuse eingebettet werden. Bei diesen Umgebungsbedingungen handelt es sich besonders im Bereich der Automobiltechnik um die eines Motorraums eines Kraftfahrzeugs. Anforderungen sind hier beispielsweise Dampfstrahlfestigkeit, Tauchdichtheit und eine Beständigkeit gegenüber Vibrationen zu nennen.

Aufgrund der aus der elektrischen Verbindung zwischen Steckverbinder und Leiterplatte resultierenden, mechanischen Verbindungen wird die Bauform der Elektronikeinheit eingeschränkt. Die Verbindung zwischen dem Steckverbinder und dem Gehäuse muss zum einen dicht ausgeführt sein, zum anderen soll die Gesamtanordnung einen möglichst geringen Bauraum beanspruchen, weswegen meist ein Steckverbinder mit einer parallel zur Leiterplattenebene verlaufenden Steckrichtung gewählt wird.

In der nicht vorveröffentlichten deutschen Patentanmeldung 103 24 047 wird eine Elektronikeinheit vorgeschlagen, die einen Steckverbinder aufweist, dessen Kontaktstifte über Metallfederstreifen mit Kontaktflächen zweier Leiterplatten elektrisch verbunden werden. Eine solche durch einen Federkraft erzeugte elektrische Verbindung erweist sich je nach Anforderung an die Elektronikeinheit jedoch nicht als ausreichend zuverlässig.

Es ist Aufgabe der Erfindung, einen Steckverbinder, eine Elektronikeinheit und ein Verfahren zum Herstellen einer solchen Elektronikeinheit zu schaffen, die eine zuverlässige elektrische Verbindung zwischen einer elektrischen Leiterplatte und einem Steckverbinder ermöglichen.

Diese Aufgabe wird durch einen Steckverbinder mit den Merkmalen von Anspruch 1, durch eine Elektronikeinheit mit den Merkmalen von Anspruch 2 und durch Verfahren zum Herstellen einer Elektronikeinheit mit den Merkmalen von Anspruch 7 gelöst.

Ein Steckverbinder weist einen ersten Kontaktstift und einen zweiten Kontaktstift auf, die als Einpresskontakte ausgeführt sind und jeweils eine Einpresszone aufweisen. Die Einpresszonen der Kontaktstifte sind so abgewinkelt, dass die Einpressrichtung des zweiten Kontaktstifts in Bezug auf die Einpressrichtung des ersten Kontaktstifts in eine andere Richtung, insbesondere in die entgegengesetzte Richtung weist. Die Einpressrichtung des zweiten Kontaktstifts ist somit in Bezug auf die Einpressrichtung des ersten Kontaktstifts räumlich um 180 ° gedreht ist.

Beim Einsatz eines solchen Steckverbinders in einer Elektronikeinheit wird mit dem ersten Kontaktstift zunächst eine erste Leiterplatte elektrisch verbunden. In einer zweiten Schritt wird eine zweite Leiterplatte mit dem zweiten Kontaktstift elektrisch verbunden. Die elektrischen Verbindungen erfolgen durch Einpressen des jeweiligen Kontaktstifts in eine Ausnehmung der dazugehörigen Leiterplatte. Hier sind die Einpresszonen des ersten und des zweiten Kontaktstifts so ausgebildet, dass die Einpressrichtung des zweiten Kontaktstifts in Bezug auf die Einpressrichtung des ersten Kontaktstifts in eine andere Richtung, insbesondere in die entgegengesetzte Richtung weist.

Eine derartige mechanische Verbindung zwischen den Kontaktstiften des Steckverbinders und der jeweiligen Leiterplatte hat eine elektrische Verbindung zur Folge, die auch bei höheren Vibrationsanforderungen ausreichend zuverlässig und mechanisch steif ist.

Weiter ist eine so ausgeführte Elektronikeinheit reparaturfähig, d. h. im Falle eines Defekts kann zunächst die zweite Leiterplatte von den zweiten Kontaktstiften des Steckverbinders und anschließend, falls erforderlich, die erste Leiterplatte von dem ersten Kontaktstift getrennt werden. Zusätzlich wird die Montage der Elektronikeinheit erheblich vereinfacht.

Die Kontaktstifte des Steckverbinders sind so ausgeführt, dass zunächst der erste Kontaktstift der ersten Leiterplatte und im Anschluss daran der zweite Kontaktstift mit der zweiten Leiterplatte verbunden wird. Hierzu ragt der erste Kontaktstift im Vergleich zum zweiten Kontaktstift ausgehend vom Steckverbinder weiter in den Rahmen hinein. Der erste und der zweite Kontaktstift kann so beim Einpressen von einem Einpresswerkzeug fixiert werden.

Vorteilhafte Ausgestaltung der Erfindung sind in den Unteransprüchen beschrieben.

Darüber hinaus können zwei Leiterplatten platzsparend in einer Gehäuseanordnung untergebracht werden, ohne dass hier direkte elektrische Verbindungen von der ersten zur zweiten Leiterplatte ausgeführt sein müssen. Alle Verbindungen verlaufen direkt von der jeweiligen Leiterplatte zum Steckverbinder. Es können auch Verbindungen zwischen der ersten und der zweiten Leiterplatte über den Steckverbinder ausgeführt sein. In diesem Fall wäre ein erster mit einem zweiten Kontaktstift elektrisch verbunden. Hierdurch wird auf der sonst als Träger fungierenden Leiterplatte Bauraum eingespart, wodurch die gesamte Elektronikeinheit eine kleinere Bauform aufweist. Ein weiterer Vorteil eines solchen Aufbaus liegt darin, dass sich die elektromagnetische Verträglichkeit (EMV) der Elektronikeinheit verbessert, da keine zusätzliche Entflechtung von Leiterbahnen der Leiterplatten im Verbindungsbereich der beiden Leiterplatten notwendig ist.

In einer ersten bevorzugten Ausführungsform weist die Elektronikeinheit eine Gehäuseanordnung auf, die einen Rahmen, einen Deckel und einen Boden aufweist. Der Steckverbinder ist hier in einer stirnseitigen Öffnung des Rahmens angeordnet.

Die erste Leiterplatte ist hierbei zwischen Boden und Rahmen und die zweite Leiterplatte zwischen Rahmen und Deckel angeordnet.

Dieser Aufbau weist den Vorteil auf, dass zum einen die elektromagnetische Verträglichkeit der in der Elektronikeinheit angeordneten Schaltungsanordnungen durch die Verwendung von geschirmten Bauräumen verbessert werden kann. Darüber hinaus kann die von elektronischen Komponenten erzeugte Verlustleistung über den als Kühlkörper ausgeführten Rahmen abgeführt werden.

Zusätzlich kann die erste Leiterplatte Ausnehmungen aufweisen, die dazu dienen, mit einem Einpresswerkzeug den zweiten Kontaktstift sowohl von der Unter- als auch von der Oberseite erreichen zu können.

Es erweist sich als besonders vorteilhaft, wenn der Steckverbinder zunächst in die stirnseitige Öffnung des Rahmens eingesetzt wird und im Anschluss daran mit der ersten und anschließend mit der zweiten Leiterplatte verbunden wird. Hierdurch können einheitliche Schnittstellen zwischen der Gehäuseanordnung und dem Steckverbinder realisiert werden. Beispielsweise können in den selben Rahmen unterschiedliche Steckverbindertypen eingesetzt werden, ohne dass die Geometrie der stirnseitigen Öffnung geändert werden muss.

Ein weiterer Vorteil liegt darin, dass zwischen Rahmen und Steckverbinder eine umlaufende Dichtung eingesetzt werden kann, die einen dichten Abschluss der Verbindung Rahmen Steckverbinder sicherstellt. Eine solche Verbindung kann auch im Reparaturfall problemlos gelöst werden, da hier anstelle von flüssig Dichtungen vorzugsweise Silikondichtringe eingesetzt werden.

In einer weiteren bevorzugten Ausführungsform ist jeweils ein Dichtelement zwischen Boden und Rahmen und/oder zwischen Deckel und Rahmen angeordnet. Diese Dichtelemente werden vorzugsweise schon vor der Montage auf der Innenseite des Bodens und/oder des Deckels aufgebracht.

Im Folgenden wird ein Ausführungsbeispiel anhand der schematischen Zeichnungen näher erläutert. Es zeigen:
- Figur 1: eine Explosionszeichnung einer erfindungsgemäßen Elektronikeinheit,
- Figuren 2a und b: verschiedene Ansichten eines Rahmens der Elektronikeinheit,
- Figur 3: eine schematische Schnittansicht der Elektronikeinheit bei der Montage einer ersten Leiterplatte,
- Figur 4: eine schematische Schnittansicht der Elektronikeinheit bei der Montage einer zweiten Leiterplatte, und
- Figur 5: eine Schnittansicht der Elektronikeinheit im montierten Zustand.

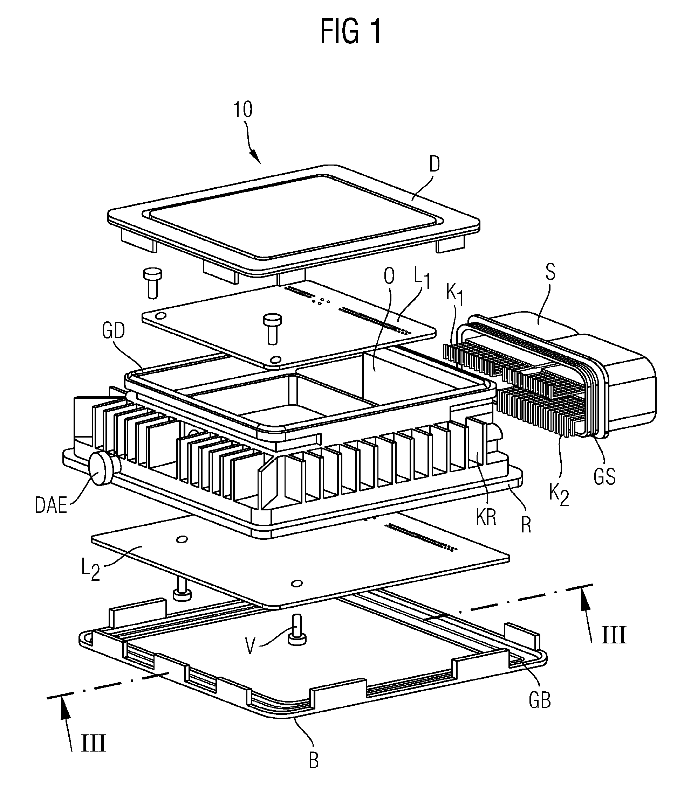

Figur 1 zeigt eine perspektivische Explosionsansicht einer Elektronikeinheit 10 mit einem Rahmen R. Der Rahmen R ist als Druckgussteil aus Aluminium gefertigt. Das steife Gussteil dient als Stabilisator der Elektronikeinheit 10. Er dient zum einen zum Abschirmen der Schaltungsanordnung gegenüber elektromagnetischer Strahlung und zum anderen als Kühlkörper für die im Inneren des Rahmens angeordneten Bauelemente BE. Der Rahmen R weist zusätzliche Kühlrippen KR auf, die Oberfläche, über die die von elektronischen Bauelementen BE erzeugte Verlustleistung an die Umgebung abgeführt werden kann, vergrößern.

Bei der Montage wird in eine stirnseitige Öffnung O des Rahmens R ein Steckverbinder S eingesetzt. Dieser Steckverbinder S weist eine Vielzahl von ersten Kontaktstiften K1 auf. Diese Kontaktstifte K1 sind als Stanzbiegeteil aus Metall ausgeführt. Die Kontaktstifte K1 weisen ausgehend vom Körper des Steckverbinders S zunächst einen ersten Teil auf, der parallel zur Fügerichtung des Steckverbinders S in die Öffnung O verläuft. Ausgehend von diesem ersten Teil ist ein zweiter Teil mit einer Einpresszone EZ in etwa um 90° in Richtung der dem Kontaktstift K1 näheren Außenseite S des Steckverbinders abgewinkelt.

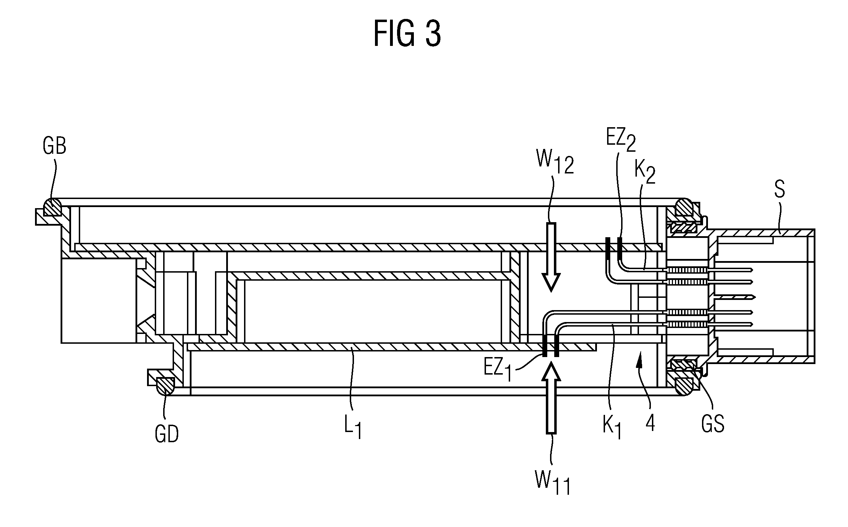

Der Steckverbinder weist weiter eine Vielzahl zweiter Kontaktstifte K2 auf, die ebenfalls als Stanzbiegeteile aus Metall ausgeführt sind und in ihrer Ausführung den ersten Kontaktstiften K1 bis auf den Unterschied entsprechend, dass der erste Teil der Kontaktstifte K2 im Vergleich zum ersten Teil der Kontaktstifte K1 kürzer ausgeführt ist und der zweite Teil der Kontaktstifte K2 mit der Einpresszone EZ2 ebenfalls um 90° in Bezug auf die Fügerichtung des Steckverbinders S gebogen ist (vergleiche Figur 3). Aufgrund der unterschiedlich gebogenen Einpresszonen EZ1 und EZ2 ist die Einpressrichtung des zweiten Kontaktstiftes K2 in Bezug auf die Einpressrichtung des ersten Kontaktstift K1 um etwa 180° gedreht. Hier sind jeweils zwei Reihen erster und zweiter Kontaktstifte K1 und K2 dargestellt. In einer Reihe sind jeweils entlang einer Geraden mehrere Kontaktstifte hintereinander angeordnet. Die zwei Reihen erste Kontaktstifte K1 und die zwei Reihen zweite Kontaktstifte K2 sind jeweils parallel zueinander angeordnet.

Auf der dem Rahmen R abgewandten Seite des Steckverbinders S sind die Kontaktstifte K1 und K2 so ausgebildet, dass sie mit einem zum Steckverbinder S passenden Gegenstück elektronisch mit einem nicht dargestellten Kabelbaum des Kraftfahrzeugs verbunden werden können.

Zwischen Steckverbinder S und Rahmen R ist eine Ringdichtung GS angeordnet. Diese Ringdichtung GS weist mehrere Dichtlippen auf, wodurch der Grad der Abdichtung erhöht wird.

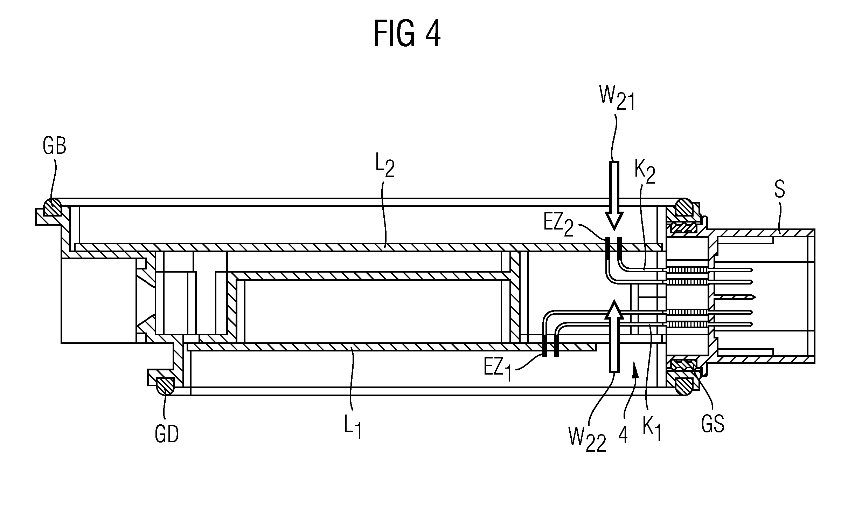

Bei der Montage wird zunächst von der in Figur 1 nach oben zeigenden Seite des Rahmens R eine erste Leiterplatte L1 in den Rahmen R eingesetzt, wobei die Einpresszonen EZ1 der Kontaktstifte K1 in Ausnehmungen der Leiterplatte L1 eingepresst werden. Im Anschluss daran wird von der entgegengesetzten Seite des Rahmens eine zweite Leiterplatte L2 eingesetzt und mit den Kontaktstiften K2 verpresst. Der Vorgang des Einpressens wird in den Figuren 3 und 4 näher erläutert.

Die Leiterplatten L1 und L2 werden im Anschluss an das Verpressen mit Verbindungselementen (hier Schrauben V) mechanisch an dem Rahmen R befestigt. Die Elektronikeinheit wird im Anschluss daran mit einem Deckel D und einem Boden B verschlossen. Zwischen Deckel D und Rahmen R ist ein erstes Dichtelement GD angeordnet. Zwischen Rahmen R und Boden B ist ein zweites Dichtelement GB angeordnet.

Im hier dargestellten Ausführungsbeispiel handelt es sich bei dem Dichtelement GD um ein flüssig aufgetragenes Dichtmittel, dass schon vor aber hauptsächlich auch nach dem Aufsetzen des Deckels aushärtet. Bei dem Dichtungselement GB handelt es sich um ein Dichtelement, das bereits bei der Fertigung des Bodens B auf diesen aufgetragen wird. Das Material aus dem die Dichtelemente GD und GB gefertigt sind richtet sich nach den Anforderungen an die Elektronikeinheit 10. Hier können beispielsweise Silikon- oder Polyurethandichtungen zum Einsatz kommen.

Die Elektronikeinheit 10 gemäß Figur 1 weist weiter ein Druckausgleichselement DAE auf, das in eine Öffnung O_{DAE} des Rahmens eingesetzt wird. Dieses Drucksausgleichselement DAE dient zum Druckausgleich zwischen dem Innenraum der Elektronikeinheit 10 und dem Außenraum. In den Luftstrom zwischen Innen- und Außenraum ist eine Membrane eingesetzt, die zwar permeabel für Gase ist, aber nicht für Flüssigkeiten. Hierdurch wird der Innenraum der Elektronikeinheit 10 vor Feuchtigkeit geschützt.

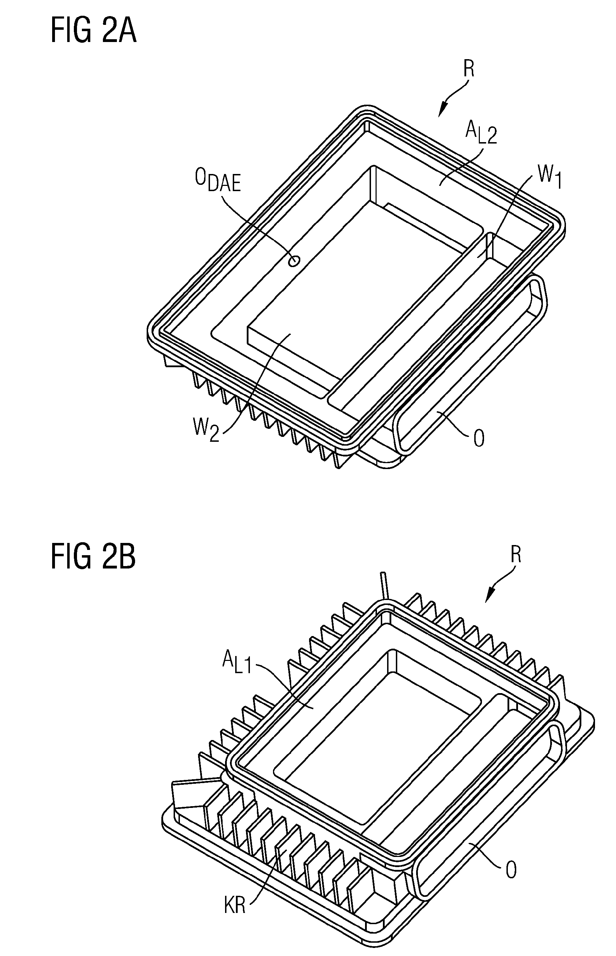

Die Figuren 2 a) und b) zeigen zwei perspektivische Ansichten des Rahmens R, wobei der Rahmen R einmal mit der durch den Boden B abgedeckten Öffnung nach oben bzw. einmal mit der durch den Deckel D abgedeckten Öffnung nach oben dargestellt ist.

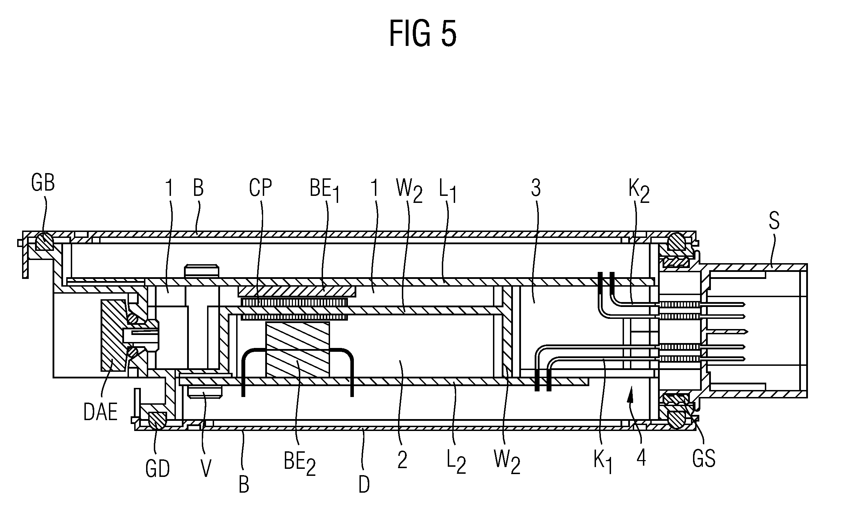

In Figur 2 a ist weiter eine erste metallische Wand W1 und eine zweite metallische Wand W2 dargestellt. Die Wand W2 dient zur Abschirmung der auf den Leiterplatten L1 und L2 angeordneten Bauelemente BE1, BE2. Die Wand W2 bildet mit den Leiterplatten L1 und L2 jeweils eine elektromagnetisch abgeschirmte Kammer 1 bzw. 2 (vergleiche Figur 5). Diese Wände W1, W2 dienen zur elektromagnetischen Abschirmung der in der Elektronikeinheit 10, speziell der in den Kammern 1 und 2 angeordneten Bauelemente BE1, BE2. Der Rahmen R weist weiter zwei Auflageflächen A_{L1} und A_{L2} auf. Über diese Auflageflächen A_{L1} und A_{L2} kann die durch Bauelemente BE1, BE2 erzeugte Wärme über die Leiterplatten L1 und L2 und deren Kupferkaschierung an den Rahmen R abgeführt werden. Weiter können diese Auflageflächen A_{L1} und A_{L2} zur Kontaktierung der Leiterbahnen L1 bzw. L2 mit Masse verwendet werden. Die Leiterplatten L1 und L2 liegen hier umlaufend auf dem Rahmen R auf und stellen somit eine thermische und/ oder elektrische Verbindung dar.

Figur 3 zeigt einen Schnitt gemäß der Linie III. - III. in Figur 1. Hier ist der Fertigungsschritt schematisch dargestellt, bei dem die ersten Kontaktstifte K1 in Ausnehmungen der ersten Leiterplatte L1 eingepresst werden. Ein Einpresswerkzeug ist hier schematisch durch zwei Pfeile W11 und W12 dargestellt. Bei dem Einpressvorgang werden die Kontaktstifte von oben durch das Werkzeug W12 fixiert, wobei die Leiterplatte L1 durch das Werkzeug W11 in Richtung der Einpresszone gedrückt wird (1. Einpressrichtung). Hierbei werden die Einpresszonen EZ1 in metallisierte Ausnehmungen der ersten Leiterplatte L1 eingepresst.

Hierbei kann prinzipiell zwischen zwei Ausführungsformen einer so genannten "Pressfit"-Verbindung unterschieden werden. Zum einen werden massive Einpresszonen in Ausnehmungen der Leiterplatte eingebracht, wobei die für die Einpressverbindung notwendigen Kräfte durch die Verformung der Leiterplattenausnehmungen aufgebracht werden.

Zum anderen gibt es elastischen Einpresszonen, die im Einpressbereich elastisch ausgebildet sind und bei denen die für die Einpressverbindung notwendigen Kräfte durch die Verformung des elastischen Einpresskontaktes aufgebracht werden.

Im folgenden Fertigungsschritt wird die zweite Leiterplatte L2 mit einer wieder schematisch durch Pfeile W21 und W22 dargestellten Einpresswerkzeug mit den Kontaktstiften K2 elektrisch und mechanisch verbunden. Hierbei sind zwischen der ersten Leiterplatte L1 und dem Steckverbinder S Ausnehmungen angeordnet, durch die die zweiten Kontaktstifte K2 durch das Werkzeug W22 fixiert werden können. Diese Ausnehmungen können zum einen so ausgeführt sein, dass die Elektronikeinheit 10 zwischen Leiterplatte L1 und Steckverbinder S einen Spalt 4 aufweist (vgl. Figur 4). Zum anderen können in eine bis an den Steckverbinder S heranreichende Leiterplatte L1 Ausnehmungen zum Durchführen des Werkzeugs W22 bei der Montage eingebracht sein.

Das Einpressen der Einpresszonen EZ2 der Kontaktstifte K2 in die zweite Leiterplatte L2 erfolgt entsprechend dem bereits beschriebenen Einpressen der Kontaktstifte K1. Unterschied ist hier jedoch, dass die Einpressrichtung der zweiten Einpresszone EZ2 in Bezug auf die erste Einpressrichtung räumlich um 180° gedreht ist (2. Einpressrichtung).

Hierbei werden die Kontaktstifte K1 und/oder K2 von dem jeweiligen Werkzeug W12 bzw. W22 während des Einpressens gehalten und unterstützt. Die Kontaktstifte K1 und K2 werden dabei auch durch das jeweilige Werkzeug W12, W22 dabei auch zentriert.

Im Gegensatz zum Stand der Technik ist hier kein Kunststoffkörper erforderlich, der die Kontaktstifte K1, K2 in Position hält, die Kontaktstifte K1, K2 liegen hier frei. Auf diese weise werden Toleranzprobleme vermieden, wie sie beispielsweise bei hochpoligen Stiftleisten mit solchen Kunststoffkörpern auftreten können.

Der Einfachheit halber sind in den Figuren 1 bis 4 keine elektronischen Bauelemente BE dargestellt. In Figur 5 sind beispielhaft zwei Bauelemente BE dargestellt, wobei ein erstes Bauelement BE1 mit der ersten Leiterplatte L1 elektrisch verbunden ist und ein zweites Bauelement BE 2, hier beispielsweise ein Kondensator mit der zweiten Leiterplatte L2 elektrisch verbunden ist. Zwischen den Bauelementen BE1 und BE2 und der zweiten metallischen Wand W2 ist hier jeweils ein Übergangselement CP, ein so genanntes "Gap Pad" angeordnet. Dieses dient dazu einen guten thermischen Übergang von den Bauelementen BE1 und BE2 zu der Wand W2 sicher zu stellen. Alternativ kann auch die Struktur der Wand W2 an die Kontur der Bauelemente BE1, BE2, die auf den Leiterplatten L1 und L2 angeordnet sind, angepasst werden. So wird ein guter thermischer Übergang bereits durch das Auftragen einer Wärmeleitpaste erreicht.

In Figur 5 sind weiter zwei elektromagnetisch geschirmte Kammern 1 und 2 dargestellt. In diesen Kammern 1 und 2 sind Bauelemente BE1, BE2 angeordnet, die aufgrund ihrer elektromagnetischen Abstrahlungen die Funktion von anderen Teilen der Schaltungsanordnung beeinflussen könnten, können so auf einfache Weise abgeschirmt werden. Zu solchen Bauelementen gehören beispielsweise mit höheren Frequenzen getaktete Prozessoren und andere im Hochfrequenz-Bereich betriebene Bauelemente.

Die Leiterplatten L1 und L2 können im Bereich der Kammern 1, 2 durchgehende Masseflächen enthalten, die im Auflagebereich der Leiterplatten L1 und L2 elektrisch mit dem Rahmen R verbunden sind. Auf diese Weise sind Kammern 1 und 2 von allen Seiten mit elektrisch leitfähigen Flächen umgeben, die mit einem Potenzial, insbesondere Masse, elektrisch verbunden sind. Der Bereich 3, in den die Kontaktstifte K1 und K2 des Steckverbinders S hineinragen, kann so ebenfalls geschirmt werden.

Da hier beide Leiterplatten L1 und L2 eine direkte Verbindung zum Steckverbinder S aufweisen, ist keine direkte elektrische Verbindung zwischen den beiden Leiterplatten L1 und L2 nötig. Hierdurch wird Platinenfläche zur Entflechtung der Leitbahnen der Leiterplatten L1 und L2 eingespart und die Störanfälligkeit in Bezug auf elektromagnetische Strahlungen (EMV) reduziert.

Alternativ zum Verschrauben der Leiterplatten L1 und L2 mit dem Rahmen R, können die Leiterplatten L1 und L2 auch mit dem Rahmen R verklebt werden. Soll hier eine umlaufende elektrische Verbindung zwischen Leiterplatte L1, L2 und Rahmen entstehen, so können hier elektrische leitfähige Klebstoffe zum Einsatz kommen.

Bauelemente, die auf der dem Rahmen R abgewandten Seite der Leitplatten L1, L2 angeordnet sind, können zur Wärmeabfuhr auch direkt mit dem Deckel D beziehungsweise dem Boden B thermisch verbunden sein. Diese thermisch leitfähige Verbindung kann auch hier durch das thermisch leitfähige Übergangselement CP ("Gap Pads") oder alternativ durch eine Anpassung der Oberfläche des Deckels D bzw. des Bodens GB erfolgen. Diese Anpassung kann beispielsweise durch ein Prägen des Bodens GB oder des Deckels D erfolgen.

## Patentansprüche

1. Steckverbinder, der einen ersten Kontaktstift (K1) und einen zweiten Kontaktstift (K2) aufweist, wobei die Kontaktstifte (K1, K2) als Einpresskontakte zum Einpressen in Ausnehmungen einer ersten und einer zweiten Leiterplatte (L1, L2) ausgeführt sind, wobei die Einpressrichtung des zweiten Kontaktstifts (K2) in Bezug auf die Einpressrichtung des ersten Kontaktstifts (K1) in eine andere Richtung, insbesondere in die entgegengesetzte Richtung, weist, **dadurch gekennzeichnet, dass** die Einpresszone (EZ1) des ersten Kontaktstiftes (K1) weiter vom Gehäuse (SG) des Steckverbinders (S) beabstandet ist, als die Einpresszone (EZ2) des zweiten Kontaktstiftes (K2), wodurch der erste und der zweite Kontaktstift (K1, K2) beim Einpressen durch ein Einspresswerkzeug (W12, W22) fixiert werden kann.

2. Elektronikeinheit, insbesondere Steuergerät für ein Kraftfahrzeug, mit
- zwei etwa parallel zueinander angeordneten mit elektrischen Komponenten (BE) bestückten Leiterplatten (L1, L2),
- einem Gehäuse (R, B, D), und
- einem Steckverbinder (S), der zumindest einen ersten Kontaktstift (K1) und zumindest einen zweiten Kontaktstift (K2) aufweist und die Kontaktstifte (K1, K2) als Einpresskontakte ausgeführt sind, wobei
die Einpressrichtung des zweiten Kontaktstifts (K2) in Bezug auf die Einpressrichtung des ersten Kontaktstifts (K1) in eine andere Richtung, insbesondere in die entgegengesetzte Richtung, weist, **dadurch gekennzeichnet, dass** die Einpresszone (EZ1) des ersten Kontaktstiftes (K1) weiter vom Gehäuse (SG) des Steckverbinders (S) beabstandet ist, als die Einpresszone (EZ2) des zweiten Kontaktstiftes (K2), wodurch der erste und der zweite Kontaktstift (K1, K2) beim Einpressen durch ein Einspresswerkzeug (W12, W22) fixiert werden kann.

3. Elektronikeinheit nach Anspruch 2, **dadurch gekennzeichnet, dass** das Gehäuse einen Rahmen (R), einen Deckel (D) und einen Boden (GB) aufweist, wobei der Rahmen (R) eine stirnseitige Öffnung (O) für den Steckverbinder (S) aufweist.

4. Elektronikeinheit nach einem der Ansprüche 2 bis 3, **dadurch gekennzeichnet, dass** die zweite Leiterplatte (L2) Ausnehmungen aufweist, die bei der Montage zum Durchführen eines Einpresswerkzeuges (W11, W12, W21, W22) dienen.

5. Elektronikeinheit nach einem der Ansprüche 2 bis 4, **dadurch gekennzeichnet, dass** die stirnseitige Öffnung (O) eine geringere Breite aufweist, als die erste und/oder die zweite Leitplatte (L1, L2).

6. Elektronikeinheit nach einem der vorhergehenden Ansprüche, **dadurch gekennzeichnet, dass** die elektrischen Komponenten (BE) nach dem Einpressen an das Gehäuse (R, B, D) thermisch angebunden sind.

7. Elektronikeinheit nach einem der vorhergehenden Ansprüche, **dadurch gekennzeichnet, dass** das Gehäuse (R, B, D) zusammen mit einer Leiterplatte (L1, L2) eine Kammer (1, 2, 3) bildet, die elektromagnetisch geschirmt ist.

8. Elektronikeinheit nach Anspruch 7, **dadurch gekennzeichnet, dass** in der Kammer (1, 2) elektronische Bauelemente (BE1, BE2) angeordnet sind, die aufgrund ihrer elektromagnetischen Abstrahlungen die Funktion von anderen Bauelementen beeinflussen könnten.

9. Verfahren zum Herstellen einer Elektronikeinheit, insbesondere eines Steuergerätes für ein Kraftfahrzeug, die die folgenden Schritte aufweist:
- Einpressen eines ersten Kontaktstiftes (K1) in eine Ausnehmung einer ersten Leiterplatte (L1),
- Einpressen eines zweiten Kontaktstiftes (K2) in eine zweite Leiterplatte (L2), wobei die Einpressrichtung des zweiten Kontaktstifts (K2) in Bezug auf die Einpressrichtung des ersten Kontaktstifts (K1) in eine andere Richtung, insbesondere in die entgegengesetzte Richtung, weist,
**dadurch gekennzeichnet, dass**
der erste Kontaktstift (K1) und der zweite Kontaktstift (K2) beim Einpressen durch ein Einpresswerkzeug (W12, W22) fixiert werden.

10. Verfahren nach Anspruch 9, **dadurch gekennzeichnet, dass** vor dem Einpressen der Kontaktstifte (K1, K2) der Steckverbinder (S) in eine Öffnung (O) eines Rahmens (R) eingesetzt wird.
